# EUROPEAN PATENT SPECIFICATION

(11) **EP 2 956 948 B1**
(45) Date of publication and mention of the grant of the patent: **18.12.2019**
(21) Application number: 14706428.1
(22) Date of filing: 07.02.2014
(51) Int. Cl.: H01F 17/00, H01F 27/28, H01L 23/64, H01L 25/10

(54) **IN SUBSTRATE COUPLED INDUCTOR STRUCTURE**
IN EINEM SUBSTRAT GEKOPPELTE INDUKTORSTRUKTUR
STRUCTURE D'INDUCTEUR COUPLÉE DANS UN SUBSTRAT

(30) Priority: 13.02.2013 US 201361764310 P; 11.03.2013 US 201313794558
(43) Date of publication of application: 23.12.2015
(73) Proprietor: Qualcomm Incorporated, San Diego, CA 92121-1714 (US)
(72) Inventor: DOYLE, James Thomas, San Diego, California 92121-1714 (US); MAHMOUDI, Farsheed, San Diego, California 92121-1714 (US); SHAYAN ARANI, Amirali, San Diego, California 92121-1714 (US)
(74) Representative: Richardson, Julie Kate
(86) International application number: PCT/US2014/015380
(87) International publication number: WO 2014/126812

(56) References cited:
- EP-A1- 2 455 953
- EP-A2- 0 979 521
- WO-A1-01/61715
- WO-A2-2011/103259
- US-A- 5 206 621
- US-A- 5 548 265
- US-A1- 2007 254 404
- US-A1- 2010 225 435
- US-A1- 2012 068 301
- US-A1- 2012 280 776

## Description

### BACKGROUND

The present application claims priority to U.S. Provisional Application No. 61/764,310 entitled "In Substrate Coupling Inductor Structure", filed February 13, 2013.

### Field

Various features relate to an inductor structure.

### Background

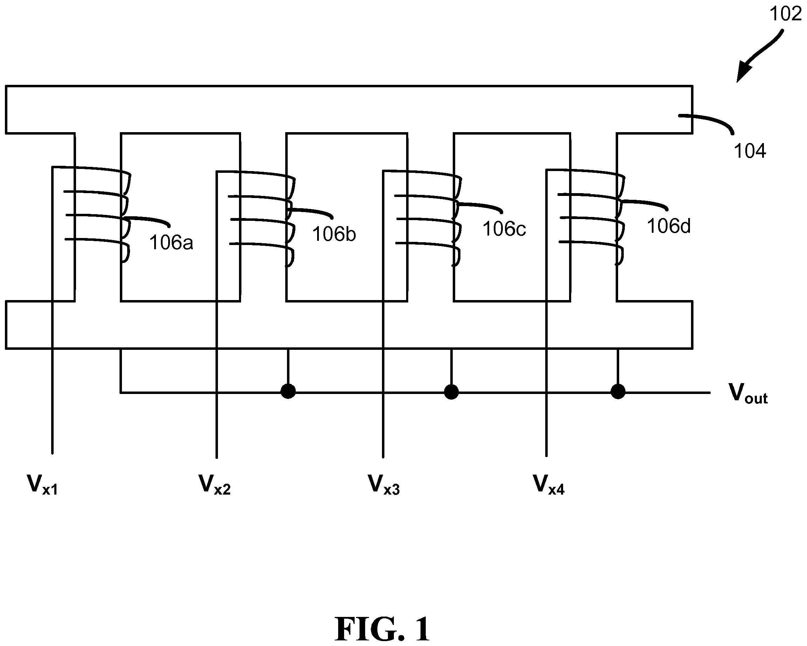

Discrete coupled inductors have traditionally been implemented using a ladder structure. As illustrated in FIG. 1, a ladder coupled inductor structure 102 may comprise a core 104 with a plurality of inductor windings 106a-d. However, such ladder structure 102 requires a custom core 104 and windings (e.g., coils). Relative to off-the-shelf inductors, the ladder structure 102 is relatively expensive. Additionally, when placing inductors within semiconductor devices, inductors taking up the smallest possible area are desired.

Consequently, there exists a need for an efficient but cost effective coupled inductor structure / configuration that occupies the smallest possible area in a die package. Ideally, such an inductor structure will be as thin as possible.
WO 2011/103259 discloses a power inductor in silicon (Plis) device comprises one or more conductive windings embedded in a silicon substrate, wherein the windings are surrounded by a magnetic material.

### SUMMARY

Various features relate to an inductor structure.

According to the present invention, an inductive structure is defined in claim 1.

The first inductor winding is laterally co-planar to the second inductor winding.

According to one aspect, the first inductor winding has a first spiral shape and the second inductor winding has a second spiral shape.

According to an aspect, the first inductor winding and the second inductor winding have an elongated circular shape.

The first inductor winding includes a first terminal and a second terminal, and the second inductor winding includes a third terminal and a fourth terminal.

According to an aspect, a thickness of the first inductor winding is less than 0.2 millimeters. In some implementations, the substrate is a silicon substrate.

The inductor structure further includes a first ferromagnetic layer above the substrate. The first ferromagnetic layer is configured to provide magnetic shielding for the in-substrate inductor structure. In some implementations, the in-substrate inductor structure further includes a second ferromagnetic layer below the substrate. The second ferromagnetic layer is configured to provide magnetic shielding for the in-substrate inductor structure.

According to an aspect, the inductor structure is integrated on a package-on-package (PoP) structure. In some implementations, the inductor structure is integrated on a surface of a package substrate. In some implementations, the inductor structure is integrated inside a package substrate.

According to one aspect, the inductor structure is incorporated into at least one of a music player, a video player, an entertainment unit, a navigation device, a communications device, a mobile device, a mobile phone, a smartphone, a personal digital assistant, a fixed location terminal, a tablet computer, and/or a laptop computer.

The substrate is located laterally between the first inductive winding and the second inductive winding. The substrate can be configured to provide structural coupling of the first and second inductive windings.

The first inductive means is laterally co-planar to the second inductive means.

According to one aspect, the first inductive means has a first spiral shape and the second inductive means has a second spiral shape.

According to an aspect, the first inductive means and the second inductive means have an elongated circular shape.

The inductive means includes a first terminal and a second terminal, and the second inductive means includes a third terminal and a fourth terminal.

According to an aspect, a thickness of the first inductor winding is less than 0.2 millimeters. The substrate is a silicon substrate.

The structure further includes a first ferromagnetic layer above the substrate. The first ferromagnetic layer is configured to provide magnetic shielding for the apparatus. In some implementations, the apparatus further includes a second ferromagnetic layer below the substrate. The second ferromagnetic layer is configured to provide magnetic shielding for the apparatus.

According to an aspect, the apparatus is integrated on a package-on-package (PoP) structure. In some implementations, the apparatus is integrated on a surface of a package substrate. In some implementations, the apparatus is integrated inside a package substrate.

According to one aspect, the apparatus is incorporated into at least one of a music player, a video player, an entertainment unit, a navigation device, a communications device, a mobile device, a mobile phone, a smartphone, a personal digital assistant, a fixed location terminal, a tablet computer, and/or a laptop computer.

Furthermore, according to the present invention, a method for providing an inductor structure is defined in claim 6.

According to an aspect, the method further thins the substrate.

Providing the first inductor includes providing the first inductor winding to be laterally co-planar to the second inductor winding.

According to an aspect, the first inductor winding has a first spiral shape and the second inductor winding has a second spiral shape.

According to one aspect, the first inductor winding and the second inductor winding have an elongated circular shape.

The first inductor winding includes a first terminal and a second terminal, and the second inductor winding includes a third terminal and a fourth terminal. The substrate is a silicon substrate.

The method further provides a first ferromagnetic layer above the substrate. The first ferromagnetic layer is configured to provide magnetic shielding for the in-substrate inductor structure. In some implementations, the method further provides a second ferromagnetic layer below the substrate. The second ferromagnetic layer is configured to provide magnetic shielding for the in-substrate inductor structure.

According to an aspect, the method further provides the inductor structure on a package-on-package (PoP) structure. In some implementations,

According to one aspect, the method further provides the inductor structure on a surface of a package substrate.

According to an aspect, the method further provides the inductor structure inside a package substrate.

According to one aspect, the method further provides the inductor structure into at least one of a music player, a video player, an entertainment unit, a navigation device, a communications device, a mobile device, a mobile phone, a smartphone, a personal digital assistant, a fixed location terminal, a tablet computer, and/or a laptop computer.

### DRAWINGS

Various features, nature and advantages may become apparent from the detailed description set forth below when taken in conjunction with the drawings in which like reference characters identify correspondingly throughout.
FIG. 1 illustrates a ladder structure inductor.
FIG. 2 illustrates an angled view of a lateral coupled inductor structure in a substrate.
FIG. 3 illustrates top and side views of a lateral coupled inductor structure in a substrate.
FIGS.4A-4B illustrate a sequence for providing / manufacturing a lateral coupled inductor structure in a substrate.
FIGS. 5A-5B illustrate another sequence for providing / manufacturing a lateral coupling inductor structure in a substrate.
FIG. 6 illustrates a flow diagram for providing / manufacturing a lateral coupling inductor structure in a substrate.
FIG. 7 illustrates another flow diagram for providing / manufacturing a lateral coupling inductor structure in a substrate.
FIG. 8 illustrates a lateral coupling inductor structure on a package on package (PoP) structure.
FIG. 9 illustrates at least one lateral coupling inductor structure on a package substrate.
FIG. 10 illustrates at least one lateral coupling inductor structure integrated in a package substrate.
FIG. 11 illustrates another lateral coupling inductor structure integrated in a package substrate.
FIG. 12 illustrates various electronic devices that may be integrated with any of the aforementioned integrated circuit, die, die package and/or substrate.

### DETAILED DESCRIPTION

In the following description, specific details are given to provide a thorough understanding of the various aspects of the disclosure. However, it will be understood by one of ordinary skill in the art that the aspects may be practiced without these specific details. For example, circuits may be shown in block diagrams in order to avoid obscuring the aspects in unnecessary detail. In other instances, well-known circuits, structures and techniques may not be shown in detail in order not to obscure the aspects of the disclosure.

### Overview

Some novel features pertain to an in-substrate inductor structure that includes a first inductor winding, a second inductor winding and a substrate. The first inductor winding includes an electrically conductive material. The second inductor winding includes an electrically conductive material. The substrate is laterally located between the first inductor winding and the second inductor winding. The substrate is configured to provide structural coupling of the first and second inductor windings. The first inductor winding is laterally co-planar to the second inductor winding. In some implementations, the first inductor winding has a first spiral shape and the second inductor winding has a second spiral shape. In some implementations, the first inductor winding and the second inductor winding have an elongated circular shape. The substrate is a silicon substrate.

### Exemplary Lateral Coupling Inductor Structure

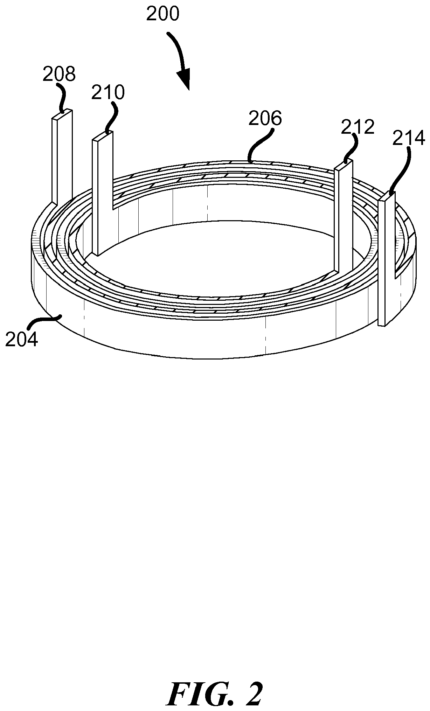

FIGS. 2-3 illustrate an example of a lateral coupling inductor structure. In some implementations, the lateral coupling inductor structure is designed / arranged in such a way as to occupy a small effective footprint / real estate with better and/or improved coupling than the ladder structure shown and described in FIG. 1. More, specifically, some implementations provide a lateral coupling inductor structure that is designed / arranged to be thinner than the ladder structure shown in FIG. 1.

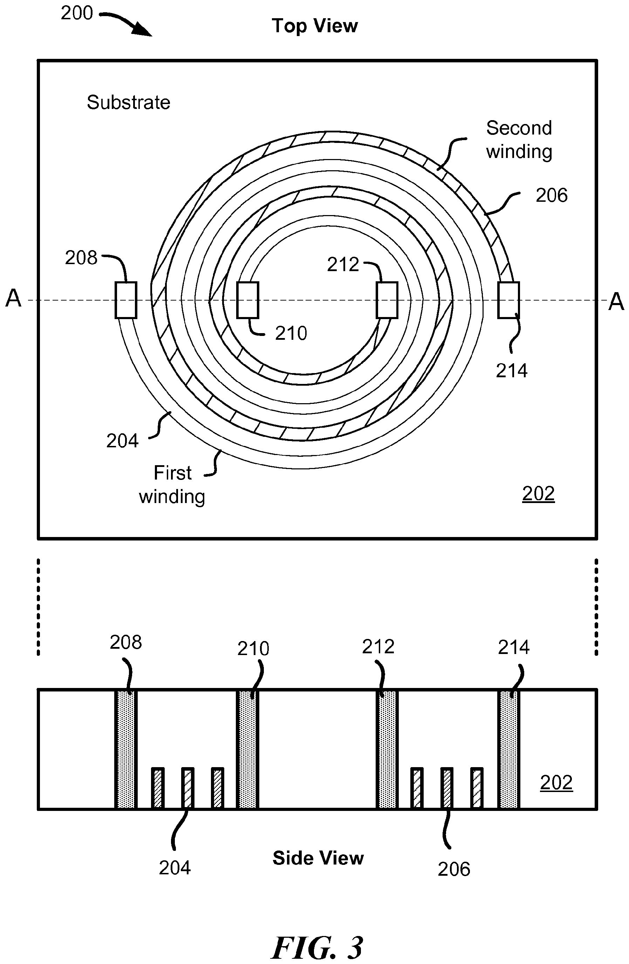

More specifically, FIG. 2 illustrates an angled view of a lateral coupling inductor structure in a substrate and FIG. 3 illustrates top and side views of the lateral coupling inductor structure in a substrate.. In some implementations, the lateral coupling / coupled inductor structure (which may include a thin substrate base) of FIGS. 2-3 may have a thickness (e.g., height) of 0.2 millimeters (mm) or less (200 microns (µm) or less). In some implementations, the lateral coupling / coupled inductor structure (which may be free of a substrate as a base) of FIGS. 2-3 has a thickness (e.g., height) of 90 microns (µm) or less. In some implementations, the thickness (e.g., height) of the inductor structure is the thickness (e.g., height) of the winding of the inductor structure.

FIG. 2 illustrates a coupled inductor structure (e.g., lateral coupling inductor structure 200) that includes a first inductor 204, a second inductor 206, and terminals 208-214. The first inductor 204 includes terminals 208-210. The second inductor 206 includes terminals 212-214. The first inductor 204 (e.g., first inductor winding) and the second inductor 206 (e.g., second inductor winding) are coupled together through a substrate (which is not visible) that provides structural coupling, stability, and/or rigidity for the lateral coupling inductor structure 200. In some implementations, the substrate is between the first inductor 204 and the second inductor 206 and holds the first and second inductors 204-206 together, allowing lateral energy coupling (e.g., energy transfer) between the two inductors 204-206. FIG. 3 further illustrates how the substrate may provide structural coupling, stability and/or rigidity for the lateral coupling inductor structure 200. In some implementations, the lateral coupling inductor structure may be referred as an in-substrate coupled inductor structure since the inductor structure may be partially or fully defined or manufactured in a substrate. The substrate may be a silicon substrate in some implementations. However, different implementations may use different materials for the substrate.

As noted above, FIG. 3 illustrates top and side views of the lateral coupling inductor structure in a substrate (e.g., in-substrate coupled inductor structure). The side view of the lateral coupling inductor structure is along the AA cross section of the top view of the lateral coupling inductor structure.

As shown in FIG. 3, the lateral coupling inductor structure 200 includes a substrate 202, a first inductor 204 and a second inductor 206. The substrate 202 may be a silicon substrate. The first inductor 204 is defined by a first inductor winding (e.g., coils). The second inductor 206 is defined by a second inductor winding (e.g., coils). The first and second inductor windings may have electrically conductive material (e.g., metal, such as copper). The first inductor winding of the first inductor 204 has a shape of a first spiral. The second inductor winding of the second inductor 206 has a shape of a second spiral. FIG. 3 also illustrates that the first inductor 204 and the second inductor 206 are integrated in the substrate 202. FIG. 3 illustrates the first inductor 204 and the second inductor 206 traverse part of the substrate 202. However, in some implementations, the first inductor 204 and/or the second inductor 206 may traverse the entire substrate 202. It should also be noted that different implementations may use different shapes for the windings of the inductors. For example, in some implementations, the inductor windings may have an elongated circular shape (e.g., race track shape). The shape of the windings may also be concentric, square, rectangular, oval, or other non-circular shapes.

In some implementations, the first spiral of the first inductor 204 and the second spiral of the second inductor 206 are positioned in the substrate 202 such that there is lateral coupling between the first inductor 204 and the second inductor 206. That is, the first inductor 204 may be configured to induce a current in the second inductor 206. In some implementations, lateral coupling refers to the transfer of energy between two inductors along the same plane (e.g., co-planar, along the same layer). In some implementations, a lateral coupling inductor structure is an inductor structure where energy transfer between two inductors occurs mostly (e.g., majority), or substantially along the same plane. In addition to providing a small footprint, a lateral coupling inductor structure may provide better coupling efficiency than other types of coupling inductor structures (e.g., vertical coupling inductor structure). Some of the properties of an inductor and/or coupled inductor structure include effective inductance, Q factor and/or effectiveness of the coupling of the inductor structure. The effectiveness of an inductor and/or inductor structure may be defined by its Q factor. A Q factor is a quality factor/value that defines the efficiency of an inductor. The higher the Q factor, the closer the inductor approaches the behavior of an ideal inductor, which is a lossless inductor. Thus, generally speaking, a higher Q factor is more desirable than a lower Q factor.

In some implementations, the first inductor 204 is the primary inductor in the inductor structure and the second inductor 206 is the secondary inductor the inductor structure. In such a configuration, the first inductor 204 (primary inductor) may induce a voltage / current in the second inductor 206 (secondary inductor). Alternatively, in some implementations, the first inductor 204 may be the secondary inductor in the inductor structure and the second inductor 206 may be the primary inductor in the inductor structure. In such a configuration, the second inductor 206 may induce a voltage / current in the first inductor 204.

Each inductor 204-206 also includes a set of pins / terminals (e.g. an input terminal and an output terminal). Specifically, the first inductor 204 includes a first input terminal 208 (e.g., _{Vx1}) and a first output terminal 2010 (e.g., _{Vout1}), and the second inductor 206 includes a second input terminal 214 (e.g., _{Vx2}) and a second output terminal 212 (e.g., _{Vout2}). However, it should be noted that different implementations may use different input and output terminal positions. For example, in some implementations, the terminal 208 may be an output terminal and the terminal 210 may be an input terminal. FIG. 3 also illustrates that the terminals 208-214 traverse the entire substrate 202. The terminals 208-214 are through substrate vias (TSVs). In some implementations, the windings of the first and second inductors 204-206 may be formed by through substrate vias (TSVs).

The coupled inductor structure 200 also includes ferromagnetic layers (not shown). A first ferromagnetic layer is located on top of the substrate 202 and a second ferromagnetic layer is located on a bottom of the substrate 202. The first and second ferromagnetic layers may not be electrically coupled to the inductors 204-206. The first and second ferromagnetic layers may be configured to reduce losses due to metal proximity (Faraday Cage). The first and second ferromagnetic layers provide shielding of the first and second inductors 204-206, which helps increase the effective inductance, the Q factor and/or effectiveness of the coupling of the coupling inductor structure 200 in some implementations. As described above, the effectiveness of an inductor may be defined by its Q factor. A Q factor is a quality factor/value that defines the efficiency of an inductor. The higher the Q factor, the closer the inductor approaches the behavior of an ideal inductor, which is a lossless inductor. Thus, generally speaking, a higher Q factor is more desirable than a lower Q factor. In some implementations, the use of the first and second ferromagnetic layers help increase the Q factor (e.g., increase effective inductance) of the coupling inductor structure 200 and provide magnetic shielding. In some implementations, the magnetic shielding keeps (e.g., concentrates) the magnetic field generated by one or more of the inductors 204-206 within the coupling inductor structure 200, which increases the effective impedance (e.g., increase Q factor) of the inductor structure 200.

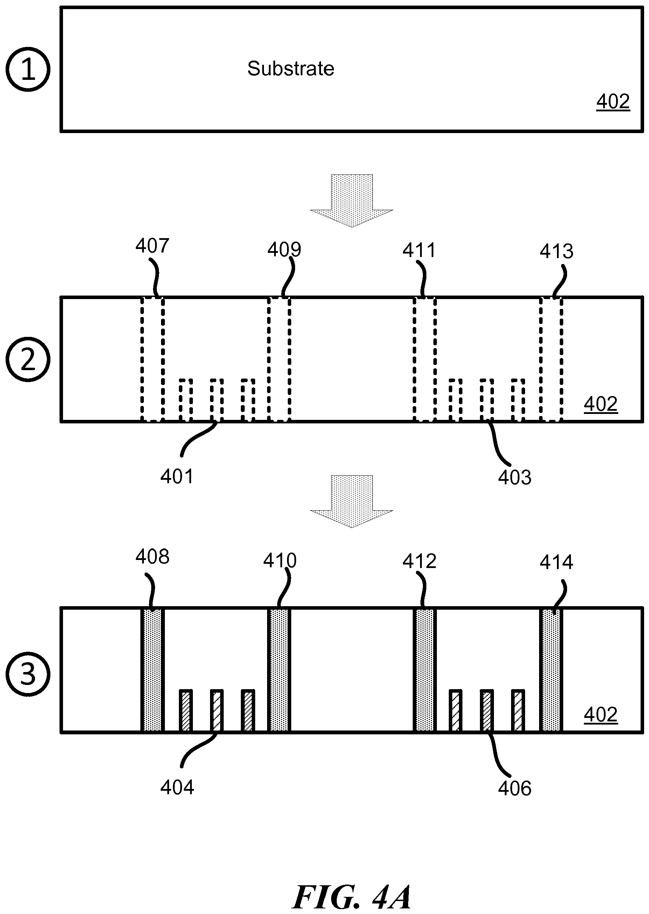

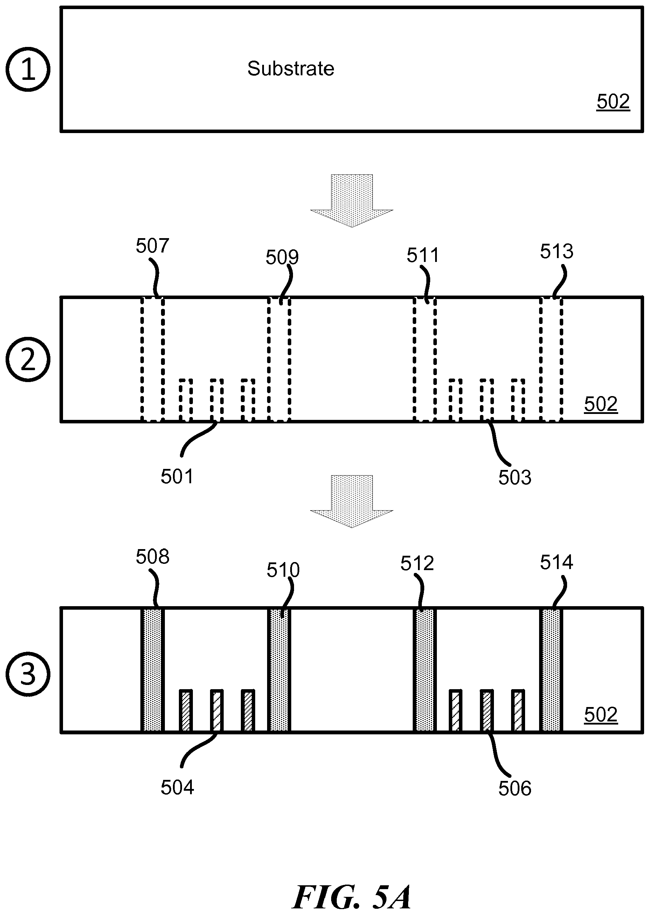

The first and second ferromagnetic layers may have high permeability (µ) and/or high B saturation. In some implementations, the permeability of a material refers to the degree of magnetization that the material obtains in response to an applied magnetic field. In some implementations, the B saturation of a material refers to the state that the material reaches when an increase in magnetic field no longer increases the magnetization of the material. An example of a ferromagnetic material could be silicon steel, Manganese-zinc ferrite (MnZn), and/or permalloy. In some implementations, the first and second ferromagnetic layers are magnetic foils. The use of ferromagnetic layers will be further described in FIGS. 4A-4B and FIGS. 5A-5B.

Having described a lateral coupling inductor structure, sequences and methods for manufacturing / providing lateral coupling inductor structures will now be described below.

### Exemplary Sequence for Providing / Manufacturing a Lateral Coupling Inductor Structure

FIGS. 4A-4B illustrates a sequence for providing / manufacturing a lateral coupling inductor structure / in-substrate inductor structure. The sequence of FIGS. 4A-4B will be described with reference to the lateral coupling inductor structure 200 of FIGS. 2-3. However, the sequence of FIGS. 4A-4B may be applicable to other lateral coupling inductor structures (e.g., other in-substrate coupled inductor structure).

The sequence starts at stage 1 of FIG. 4A with a substrate 402. The substrate 402 is a silicon substrate. In some implementations, the substrate 402 may be thinned.

At stage 2, several cavities (e.g., cavities 401, 403, 407, 409, 411, 413) are formed in the substrate 402. Different implementations may form the cavities differently. The cavities may be formed at the same time or in sequence. In some implementations, the cavities are formed by etching / drilling holes in the substrate 402. The etching / drilling of the cavities may be performed by a laser in some implementations. In some implementations, the etching is performed by chemical etching. Different implementations may form the cavities in different locations of the substrate 402. As shown in stage 2, the cavities 401 and 403 traverse part of the substrate 402. The cavities 407, 409, 411 and 413 traverse the entire substrate 402.

At stage 3, the cavities (e.g., cavities 401, 403, 407, 409, 411, 413) are filled with a material (e.g., metal such as copper). Different implementations may fill the cavities differently. The cavities may be filled at the same time and/or sequentially. In some implementations, the filling of the cavities forms the inductors and terminals in the substrate 402. For example, the filing of the cavity 401 with metal (e.g., copper) forms the first inductor 404. Similarly, the filing of the cavity 403 with metal (e.g., copper) forms the second inductor 406. In some implementations, the first inductor 404 is the first inductor 204 of FIGS. 2-3. In some implementations, the second inductor 406 is the second inductor 206 of FIGS. 2-3. Moreover, the filing of the cavities 407, 409, 411 and 413 respectively form terminals 408, 410, 412 and 414. In some implementations, terminals 408, 410, 412 and 414 may be terminals 208, 210, 212 and 214 of FIGS. 2-3.

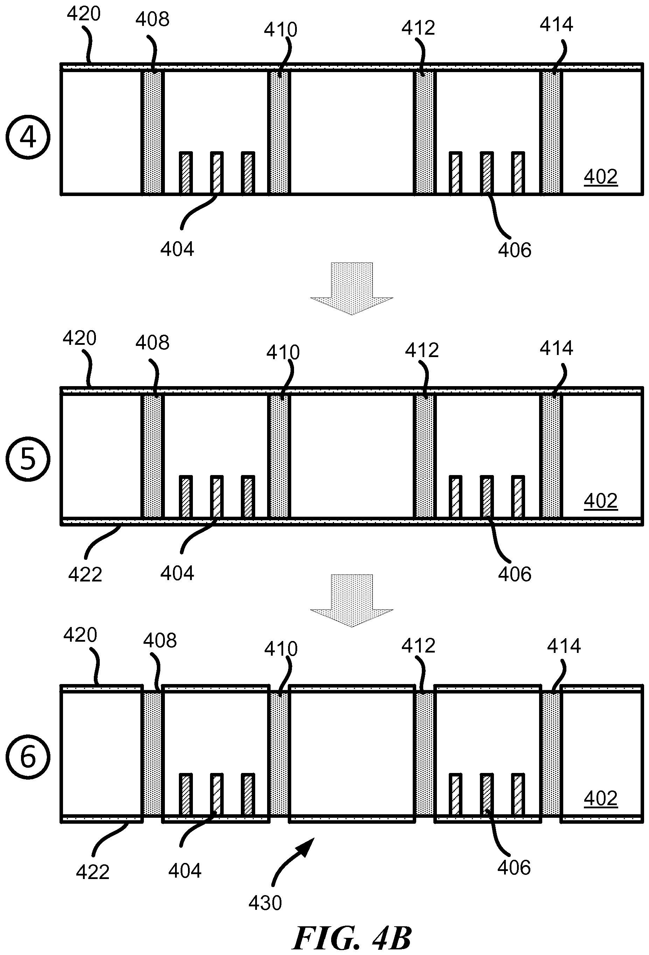

At stage 4 of FIG.4B, a first side (e.g. top side/portion) of the substrate 402 is coated with a first layer 420 having a ferromagnetic material. In some implementations, coating the first side of the substrate 402 with a ferromagnetic material may include depositing a ferromagnetic film layer (e.g., layer 420) on the substrate 402. The ferromagnetic material may have high permeability and high B saturation in some implementations. In some implementations, the ferromagnetic layer 420 provides magnetic shielding and helps increase the effectiveness of the inductor structure.

At stage 5, a second side (e.g. bottom side/portion) of the substrate 402 is coated with a second layer 422 having a ferromagnetic material. In some implementations, coating the second side of the substrate 402 with a ferromagnetic material may include depositing a ferromagnetic film layer (e.g., layer 422) on the substrate 402. The ferromagnetic material may have high permeability and high B saturation in some implementations. In some implementations, the ferromagnetic layer 422 provides magnetic shielding and helps increase the effectiveness of the inductor structure.

At stage 6, some portions of the ferromagnetic layers 420-422 are removed (e.g., etched) to expose one or more terminals / pins (e.g., terminal 408, which is a form of through substrate via (TSV)). Stage 6 illustrates both side of the terminals (e.g., terminals 408-414) are exposed. However, in some implementations, only one side of the terminal may be exposed. For example, in some implementations, the top side of the terminal 408 may be exposed, while the bottom side of the terminal 410 may be exposed. Different implementations may expose the ends of the terminals differently. Stage 6 illustrates one example of an inductor structure 430 that includes ferromagnetic layers in some implementations.

### Exemplary Sequence for Providing / Manufacturing a Lateral Coupling Inductor Structure

In some implementations, the coupling inductor structure may be thinned to further decrease the thickness (e.g., height) of the coupling inductor structure. FIGS. 5A-5B illustrates a sequence for providing / manufacturing a lateral coupling inductor structure / in-substrate inductor structure that has been thinned. The sequence of FIGS. 5A-5B will be described with reference to the lateral coupling inductor structure 200 of FIGS. 2-3. However, the sequence of FIGS. 5A-5B may be applicable to other lateral coupling inductor structures (e.g., other in-substrate coupled inductor structure).

The sequence starts at stage 1 of FIG. 5A with a substrate 502. The substrate 502 is a silicon substrate. Different implementations may use different substrates. In some implementations, the substrate 502 may be thinned.

At stage 2, several cavities (e.g., cavities 501, 503, 507, 509, 511, 513) are formed in the substrate 502. Different implementations may form the cavities differently. The cavities may be formed at the same time or in sequence. In some implementations, the cavities are formed by etching / drilling holes in the substrate 502. The etching / drilling of the cavities may be performed by a laser in some implementations. In some implementations, the etching is performed by chemical etching. Different implementations may form the cavities in different locations of the substrate 502. As shown in stage 2, the cavities 501 and 503 traverse part of the substrate 502. The cavities 507, 509, 511 and 513 traverse the entire substrate 502.

At stage 3, the cavities (e.g., cavities 501, 503, 507, 509, 511, 513) are filled with a material (e.g., metal such as copper). Different implementations may fill the cavities differently. The cavities may be filled at the same time and/or sequentially. In some implementations, the filling of the cavities forms the inductors and terminals in the substrate 502. For example, the filing of the cavity 501 with metal (e.g., copper) forms the first inductor 504. Similarly, the filing of the cavity 503 with metal (e.g., copper) forms the second inductor 506. In some implementations, the first inductor 504 is the first inductor 204 of FIGS. 2-3. In some implementations, the second inductor 506 is the second inductor 206 of FIGS. 2-3. Moreover, the filing of the cavities 507, 509, 511 and 513 respectively form terminals 508, 510, 512 and 514. In some implementations, terminals 508, 510, 512 and 514 may be terminals 208, 210, 212 and 214 of FIGS. 2-3.

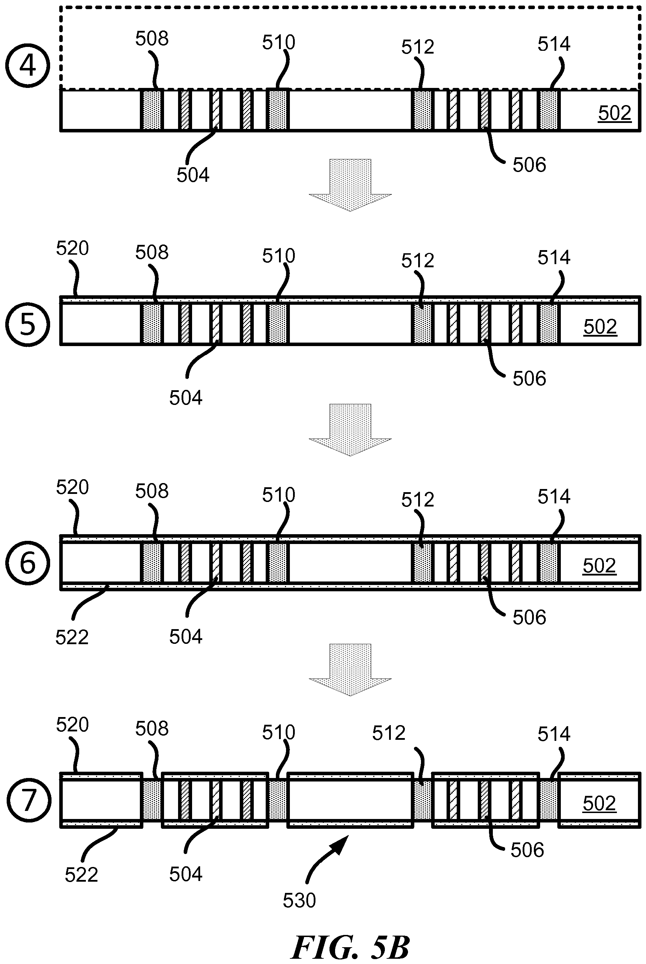

At stage 4 of FIG. 5B, a portion of the substrate 502 has been removed (e.g., thinned). Different implementations may remove portions of the substrate 502 differently. In some implementations, a top portion or bottom portion is removed. In some implementations, a combination of a top portion and a bottom portion of the substrate 502 is removed. Moreover, different implementations may use different methods for removing (e.g., etching / thinning) the substrate 502. For example, in some implementations, a laser is used to thin the substrate 502. In some implementations, a chemical process may be used to thin the substrate 502. It should be noted that the thinning of the substrate may be performed at a different stage in some implementations. For example, the thinning of the substrate may be performed after stage 1, when the substrate is provided in some implementations.

At stage 5, a first side (e.g. thinned top side/portion) of the substrate 502 is coated with a first layer 520 having a ferromagnetic material. In some implementations, coating the first side of the substrate 502 with a ferromagnetic material may include depositing a ferromagnetic film layer (e.g., layer 520) on the substrate 502. The ferromagnetic material may have high permeability and high B saturation in some implementations. In some implementations, the ferromagnetic layer 520 provides magnetic shielding and helps increase the effectiveness of the inductor structure.

At stage 6, a second side (e.g. thinned bottom side/portion) of the substrate 502 is coated with a second layer 522 having a ferromagnetic material. In some implementations, coating the second side of the substrate 502 with a ferromagnetic material may include depositing a ferromagnetic film layer (e.g., layer 522) on the substrate 502. The ferromagnetic material may have high permeability and high B saturation in some implementations. In some implementations, the ferromagnetic layer 522 provides magnetic shielding and helps increase the effectiveness of the inductor structure.

At stage 7, some portions of the ferromagnetic layers 520-522 are removed (e.g., etched) to expose one or more terminals / pins (e.g., terminal 508, which is a form of through substrate via (TSV)). Stage 7 illustrates both side of the terminals (e.g., terminals 508-514) are exposed. However, in some implementations, only one side of the terminal may be exposed. For example, in some implementations, the top side of the terminal 508 may be exposed, while the bottom side of the terminal 510 may be exposed. Different implementations may expose the ends of the terminals differently. Stage 7 illustrates one example of an inductor structure 530 that includes ferromagnetic layers in some implementations.

In some implementations, the inductor structure (which may include a thin substrate base) of FIGS. 4A-4B and 5A-5B may have a thickness (e.g., height) of 0.2 millimeters (mm) or less (200 microns (µm) or less). In some implementations, the inductor structure (which may be free of a substrate as a base) of FIGS. 4A-4B and 5A-5B has a thickness (e.g., height) of 90 microns (µm) or less. In some implementations, the thickness (e.g., height) of the inductor structure is the thickness (e.g., height) of the winding of the inductor structure.

Having described a sequence for manufacturing a lateral coupling inductor structure, an overview method for manufacturing a lateral coupling inductor structure will now be described below.

### Exemplary Method for Providing / Manufacturing a Lateral Coupling Inductor Structure

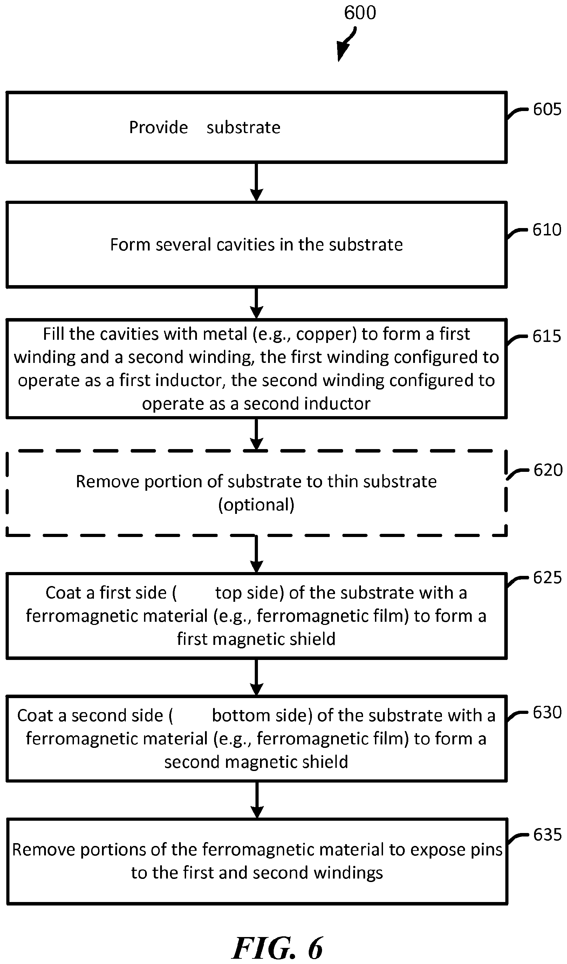

FIG. 6 illustrates a flow diagram of a method for providing / manufacturing a lateral coupling inductor structure. In some implementations, the method of FIG. 6 is used to manufacture / provide the lateral coupling inductor structure 200 of FIGS. 2-3 and/or inductor structures 430 and 530 of FIG. 4B and FIG. 5B.

The method provides (at 605) a substrate (e.g., substrate 202). The substrate is a silicon substrate. Different implementations may use different substrates. In some implementations, providing (at 605) the substrate may include receiving / providing a substrate from a substrate supplier.

The method forms (at 610) several cavities (e.g., cavities 401, 403, 407, 409, 411, 413) in the substrate. Different implementations may form the cavities differently. In some implementations, forming (at 610) the cavities includes etching and/or drilling holes in the substrate. The etching / drilling of the cavities may be performed by a laser in some implementations. In some implementations, the etching is performed by chemical etching. Different implementations may form the cavities in different locations of the substrate. The cavities that are formed (at 610) traverse the substrate 202 according to the implementation as shown in stage 2 in fig. 4A.

The method fills (at 615) the cavities (e.g., cavities 401, 403, 407, 409, 411, 213) in the substrate with a metal material (e.g., copper). Different implementations may fill the cavities differently. The cavities may be filled at the same time and/or sequentially. In some implementations, the filling (at 615) of the cavities forms the inductors and terminals in the substrate. For example, referring back to FIG.4A and 5A, the filing (at 615) of the cavity 401 with metal (e.g., copper) forms the first inductor 404 in some implementations. Similarly, the filing of the cavity 403 with metal (e.g., copper) forms the second inductor 406. Moreover, the filing (at 615) of the cavities 407, 409, 411 and 413 respectively form the terminals 408, 410, 412 and 414 in some implementations.

The method may optionally remove (at 620) a portion of the substrate to thin the substrate. In some implementations, the removal / thinning of the substrate may be performed after a substrate is provided (at 605) and/or when the cavities are formed (at 610) in the substrate. Different implementations may remove portions of the substrate differently. In some implementations, a top portion or bottom portion is removed. In some implementations, a combination of a top portion and a bottom portion of the substrate is removed. Moreover, different implementations may use different methods for removing (e.g., etching / thinning) the substrate. For example, in some implementations, a laser is used to remove / thin the substrate. In some implementations, a chemical etching process may be used to remove / thin the substrate.

The method coats (at 625) a first side (e.g. thinned top side/portion) of the substrate with a first layer having a ferromagnetic material. In some implementations, coating (at 625) the first side of the substrate with a ferromagnetic material may include depositing a ferromagnetic film layer on the substrate. The ferromagnetic material may have high permeability and high B saturation in some implementations. In some implementations, the first ferromagnetic layer provides magnetic shielding and helps increase the effectiveness of the inductor structure.

The method coats (at 630) a second side (e.g. thinned bottom side/portion) of the substrate with a second layer having a ferromagnetic material. In some implementations, coating (at 630) the second side of the substrate with a ferromagnetic material may include depositing a ferromagnetic film layer on the substrate (e.g., substrates 202, 402, 502). The ferromagnetic material may have high permeability and high B saturation in some implementations. In some implementations, the second ferromagnetic layer provides magnetic shielding and helps increase the effectiveness of the inductor structure.

The method further removes (at 635) portions of the first and second ferromagnetic layers to expose one or more terminals / pins (e.g., terminal 508, which is a form of through substrate via (TSV)). In some implementations, removing portions of the ferromagnetic layers includes etching portions of the ferromagnetic layers. In some implementations, both sides of the terminals (e.g., terminals 508-514) are exposed. However, in some implementations, only one side of the terminal may be exposed. For example, in some implementations, the top side of the terminal 508 may be exposed, while the bottom side of the terminal 210 may be exposed. Different implementations may expose the ends of the terminals differently.

Having described a specific method for providing / manufacturing a coupled inductor structure, a general method for providing / manufacturing a coupled inductor structure will now be described below.

### Exemplary Method for Manufacturing a Lateral Coupled Inductor Structure

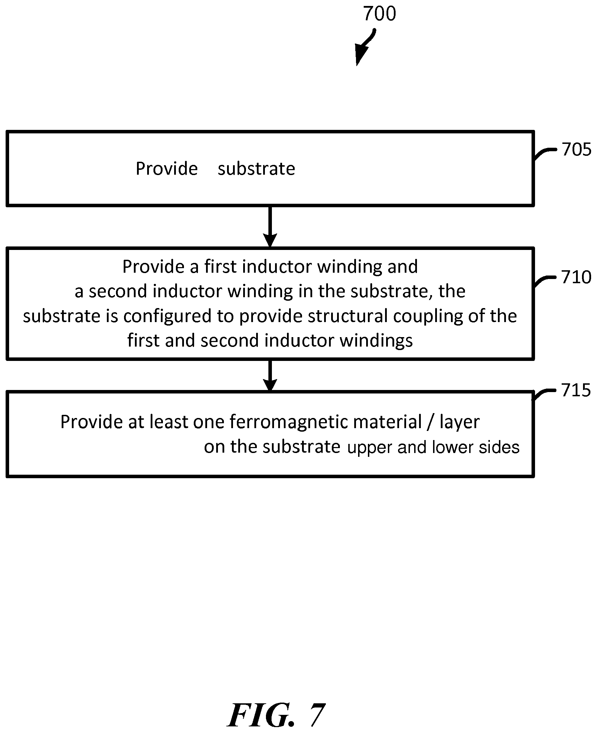

FIG. 7 illustrates a flow diagram of a method for manufacturing a lateral coupled inductor structure. In some implementations, the method of FIG. 7 is used to manufacture / provide the lateral coupled inductor structure 200 of FIGS. 2-3 and/or inductor structures 430 and 530 of FIG. 4B and FIG. 5B.

The method provides (at 705) a substrate (e.g., substrate 202). The substrate is a silicon substrate. In some implementations, providing (at 705) the substrate may include receiving / providing a substrate from a substrate supplier.

The method provides (at 710) a first inductor winding and a second inductor winding in the substrate. In some implementations, substrate is configured to provide structural coupling of the first and second inductor windings. Different implementations may provide the first inductor winding and the second inductor winding in the substrate differently. In some implementations, providing the first and second inductor windings includes providing a metal layer (e.g., copper) in the substrate (e.g., in cavities of the substrate).

In some implementations, providing the first and second inductor windings includes forming several cavities (e.g., cavities 401, 403, 407, 409, 411, 413) in the substrate. Different implementations may form the cavities differently. In some implementations, forming the cavities includes etching and/or drilling holes in the substrate. The etching / drilling of the cavities may be performed by a laser in some implementations. In some implementations, the etching is performed by chemical etching. Different implementations may form the cavities in different locations of the substrate.

In some implementations, providing the first and second inductor windings includes filling the cavities (e.g., cavities 401, 403, 407, 409, 411, 413) in the substrate with a metal material (e.g., copper). Different implementations may fill the cavities differently. The cavities may be filled at the same time and/or sequentially. In some implementations, the filling of the cavities forms the inductors and terminals in the substrate. For example, referring back to FIG.4A and 5A, the filing of the cavity 401 with metal (e.g., copper) forms the first inductor winding 404. Similarly, the filing of the cavity 403 with metal (e.g., copper) forms the second inductor winding 406. Moreover, the filing of the cavities 407, 409, 411 and 413 respectively form the terminals 408, 410, 412 and 414, in some implementations.

The method provides (at 715) at least one ferromagnetic layer on a first top side of the substrate. Providing the at least one ferromagnetic layer includes coating a top side (e.g. thinned top side/portion) of the substrate with a first layer having a ferromagnetic material. In some implementations, coating the first side of the substrate with a ferromagnetic material may include depositing a ferromagnetic film layer on the substrate. The ferromagnetic material may have high permeability and high B saturation in some implementations. In some implementations, the first ferromagnetic layer provides magnetic shielding and helps increase the effectiveness of the inductor structure.

According to the present invention, the at least one ferromagnetic layer also includes coating a second bottom side (e.g. thinned bottom side/portion) of the substrate with a second layer having a ferromagnetic material. Coating the second side of the substrate with a ferromagnetic material may include depositing a ferromagnetic film layer on the substrate. The ferromagnetic material may have high permeability and high B saturation in some implementations. In some implementations, the second ferromagnetic layer provides magnetic shielding and helps increase the effectiveness of the inductor structure.

### Exemplary Substrate-less Coupled Inductor Structure on Package-on-Package

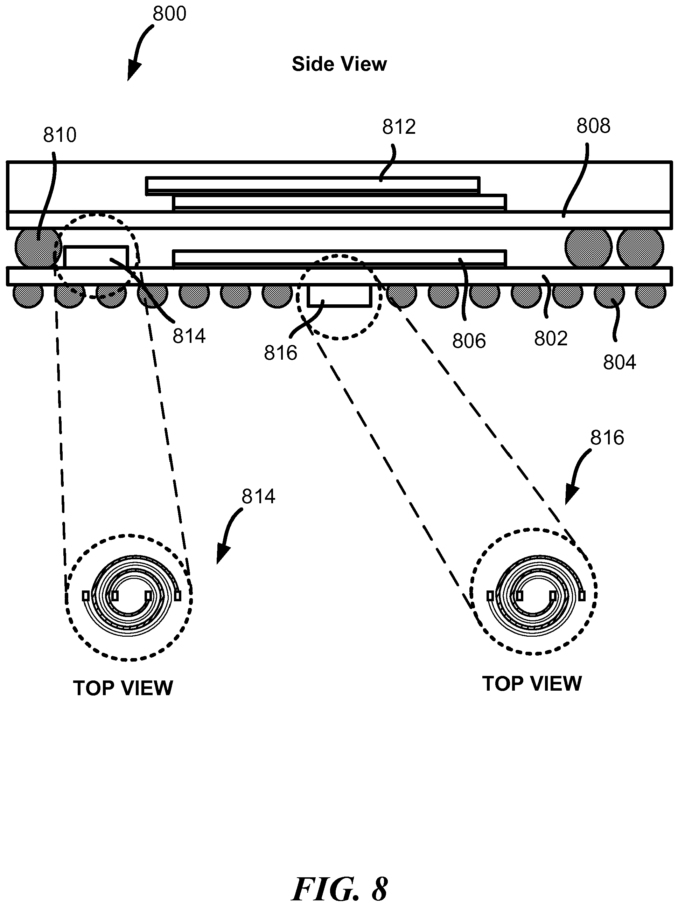

In some implementations, one or more of the coupled inductor structures (e.g., inductor structures 200, 430, 530) may be coupled on a substrate within a package-on-package (PoP) structure. FIG. 8 illustrates a side view of a package-on-package (PoP) structure 800 that includes coupled inductor structures. As illustrated in FIG. 8, the PoP structure 800 includes a first package substrate 802, a first set of solder balls 804, a first die 806, a second package substrate 808, a second set of solder balls 810, a second set of dies 812, a first inductor structure 814, and a second inductor structure 816. The first and second inductor structures 814-816 may be the inductor structures 200, 430 and/or 530 of FIGS. 2-3, FIG. 4B and FIG. 5B. The first die 806 may be a logic die. The second set of dies 812 may be stacked memory dies in some implementations.

The first package of the PoP structure 800 may include the first package substrate 802, the first set of solder balls 804 and the first die 806. The first package of the PoP structure 800 may also include the first and second inductor structures 814-816. The first die 806 may be an Application Specific Integrated Circuit (ASIC) die in some implementations. The first inductor structure 814 may be integrated on the top surface of the first package substrate 802. As shown in FIG. 8, one or more solder balls may be removed to place the first inductor structure 814 on the top surface of the first package substrate 802.

An inductor structure may also be located on the bottom surface of a package substrate. As further shown in FIG. 8, the second inductor structure 816 is located on the bottom surface of the first package substrate 802. One or more of the first set of solder balls 810 may be removed to allow the second inductor structure 816 to be placed on the bottom of the first package substrate 802.

### Exemplary Coupled Inductor Structure on Package

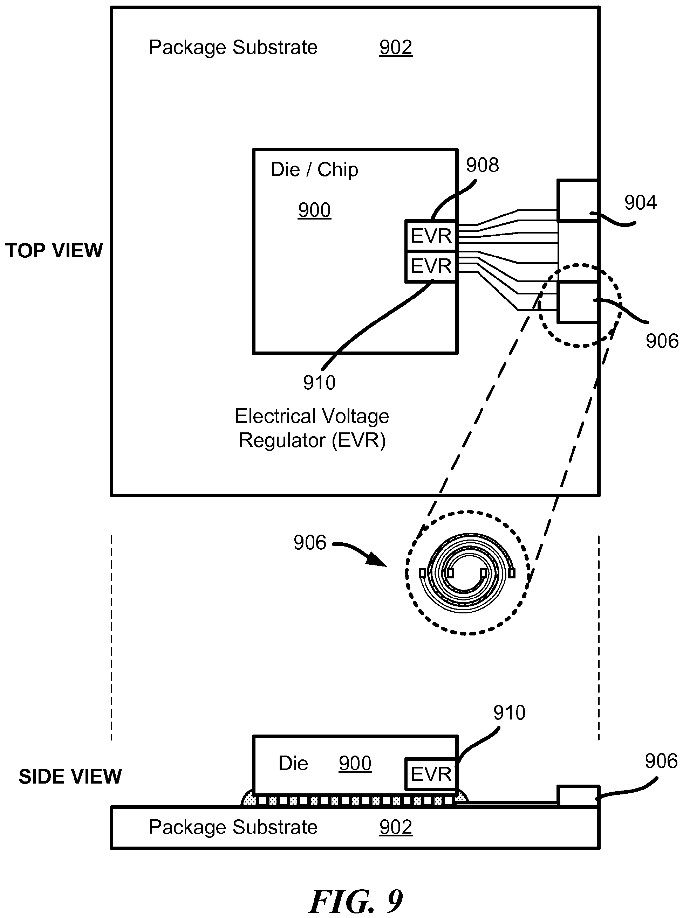

In some implementations, one or more of the coupled inductor structures (e.g., inductor structures 200, 430, 530) may be coupled on a substrate within a semiconductor package. As illustrated in FIG. 9, a die/chip 900 may be mounted on a package substrate 902. FIG. 9 also illustrates two coupled inductor structures on the surface of the package substrate 902. Specifically, FIG. 9 illustrates a first inductor structure 904 and a second inductor structure 906 on the package substrate 902. The first and second inductor structures 904-906 are coupled to the die 900 through a set of wiring (e.g., traces). In some implementations, the first and second inductor structures 904-906 may be one of the inductor structures 200, 430, 530 shown and described in FIGS. 2-3, FIG. 4B and FIG. 5B.

In some implementations, one or more of the inductors from the inductor structures 904-906 may operate on different voltages. In some implementations, one or more electrical voltage regulators (EVRs) 908-910 may be used to regulate the voltage / current that is provided (e.g., supplied) to one or more of the inductors in the inductor structures 904-906. In one example, a first EVR 908 may be used to regulate and/or provide a voltage /current to the first inductor structure 904. The first EVR 908 may also regulate the phase of the voltage / current that is provided to one or more inductors of the first inductor structure 904. Similarly a second EVR 910 may be used to regulate and/or a voltage to the second inductor structure 906. The second EVR 910 may also regulate the phase of the voltage / current that is provided to one or more inductors of the first inductor structure 906. As shown in FIG. 9, the first and second EVRs 908-910 are located on the die 900. However, in some implementations, the EVRs 908-910 may be coupled to the die 900 but physically separate from the die 900. As further shown in FIG. 9, in some implementations, the combined dimensions of the first and second EVRs 908-910 may be 2 mm x 2 mm or less. However, different implementations may have EVRs 908-910 with different dimensions.

In some implementations, the spacing between the die 900 and one or both of the inductor structures 904-906 is 2 mm or less. The spacing may be defined as the edge to edge distance between two components (e.g., distance between the edge of a die and the edge of structure). In some implementations, the spacing between the die 900 and the outer edge of the structure (e.g., inductor structure 904) is greater than 9 mm and lesser than 5 mm. However, different implementations may have different spacing between the die 900 and one or more of the inductor structure 904-306.

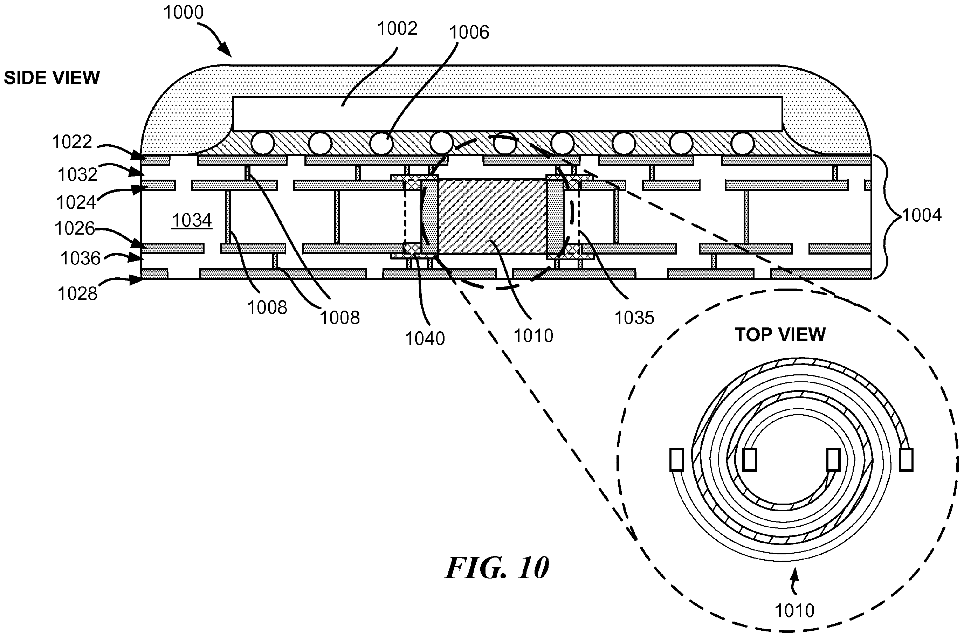

In some examples, the substrate 902 may be part of a package-on-package (PoP) device or an encapsulated package substrate (EPS) (which is further described below with reference to FIGS. 10-11). Consequently, the thickness (e.g., height) of the inductor structures 902-904 is kept to the less than or equal to the thickness of die/chip 900 (e.g., 0.2 mm or less) in some implementations.

Having described an exemplary coupled inductor structure, several package substrates that include such coupled inductor structures will now be described below.

### Exemplary Package Substrate with Coupled Inductor Structure

In some implementations, one or more of the coupled inductor structures (e.g., inductor structure 200, 430, 530) may be coupled inside a substrate (e.g., package substrate) within a semiconductor package. FIGS. 10-11 illustrate examples of a coupled inductors structure in a substrate in some implementations. Specifically, FIG. 10 illustrates a cross-sectional, schematic view of an IC package 1000 according to one aspect of the disclosure. The IC package 1000 includes an IC die 1002 (e.g., memory circuit, processing circuit, applications processor, etc.) for an electronic device, such as, but not limited to, a mobile phone, laptop computer, tablet computer, personal computer, etc. The IC package 1000, and in particular, the IC die 1002 may be supplied power (e.g., provided nominal supply voltages and currents) from a power management integrated circuit (PMIC) (not shown) through a power delivery network (PDN) (portions of the PDN external to the IC package 1000 are not shown) associated with the electronic device.

The IC die 1002 is electrically coupled to a multi-layer package substrate 1004 below it in a flip-chip style. For example, one or more soldering balls 1006 may electrically couple the die 1002 to metal traces located within a first metal layer 1022 of the package substrate 1004. According to other aspects, the IC die 1002 may be wire bonded to the package substrate 1004. The package substrate 1004 may be, for example, a four metal layer laminate substrate. In other aspects, the package substrate 1004 may have three or more metal layers, including five, six, seven, eight, nine, or ten metal layers.

The four layer package substrate 1004 shown includes the first metal layer 1022 (e.g., first outer metal layer), a second metal layer 1024 (e.g., first inner metal layer), a third metal layer 1026 (e.g., second inner metal layer), and a fourth metal layer 1028 (e.g., second outer metal layer. Each of the metal layers 1022, 1024, 1026, 1028 are generally separated from one another by a plurality of insulating layers 1032, 1034, 1036 that may be composed of one or more dielectric materials, such as, but not limited to, epoxy and/or resin. In particular, the first insulating layer 1034 in the middle of the package substrate 1004 may be thicker than the other layers and also provides structural rigidity to the package substrate 1004. A plurality of metal vertical interconnect accesses (vias) 1008 electrically couple traces of the plurality of metal layers 1022, 1024, 1026, 1028 of the package substrate 1004 to each other where desired.

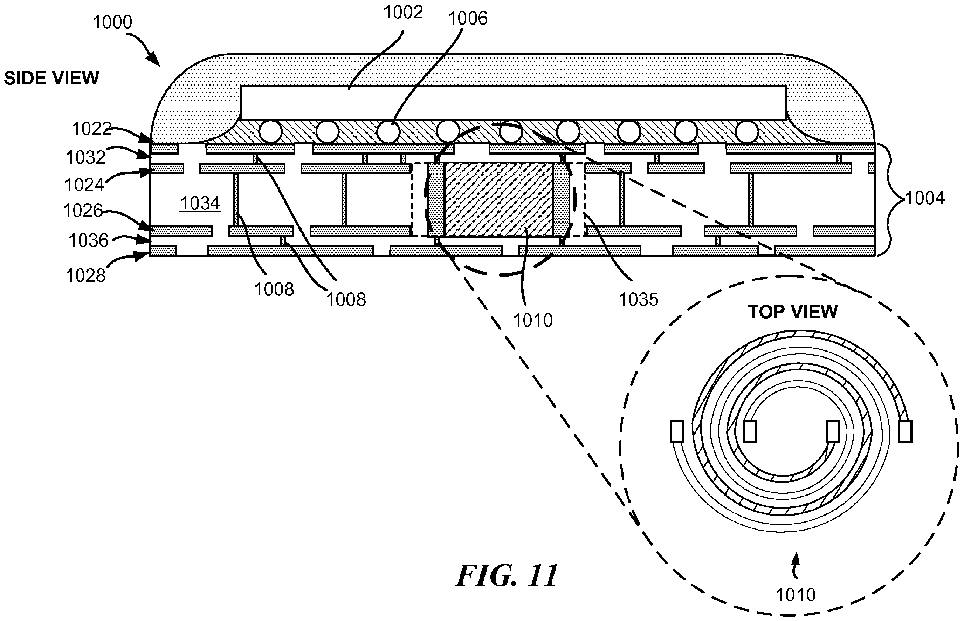

The package substrate 1004 includes a cavity 1035 (indicated by the dashed line box) that houses an embedded passive substrate (EPS) discrete circuit component (DCC) 1010, such as a capacitor, resistor, or inductor. In some implementations, the EPS discrete circuit component is the coupled inductors structure described herein (e.g., coupled inductors structure of FIGS. 2-3). It should be noted that the DCC 1010 is a conceptual representation of a DCC and does not necessarily represent exactly how the DCC (e.g., coupled inductors structure) is formed and coupled in the substrate. Rather, the DCC 1010 in FIG. 10 and 11 is merely intended to show a possible location of a DCC in a substrate. Different implementations may use different configurations and designs to couple the electrodes of the DCC to the vias in the substrate. For example, a first electrode (which is coupled to a first conductive layer) for the DCC may be coupled to the top left vias while a second electrode (which is coupled to a second conductive layer) for the DCC may be coupled to the top right vias in some implementations.

The cavity 1035 may occupy or be located within a portion of the first insulator layer 1034, and also one or more of the inner metal layers 1024, 1026. In the illustrated example, the DCC 1010 may be, for example, a discrete capacitor (e.g., "decoupling capacitor"). According to one aspect, the discrete capacitor 1010 helps reduce the impedance at a range of frequencies of the PDN by balancing inductive components of the impedance due to the IC package 1000 (e.g., inductance caused by traces, vias, metal lines, etc. associated with the package substrate 1004). The package substrate 1004 may have a plurality of cavities each housing a separate EPS discrete circuit component.

Among other things, the package substrate 1004 may comprise one or more via coupling components (e.g., via coupling component 1040) that are electrically coupled to electrodes of the DCC 1010. The via coupling components serve as a means for increasing the available surface area to which a plurality of vias may couple to (e.g., a first end of each via may couple to the via coupling components). The via coupling components are composed of a conductive material, such as a metal or metal alloy (e.g., copper, aluminum, and/or titanium nitride, etc.). According to one aspect, the via coupling components are made of one or more of the same metals that comprise the inner metal layers 1024, 1026.

According to one aspect, a first via coupling component is electrically coupled to both a first electrode of the DCC 1010 and a first metal trace within the first inner metal layer 1024; a second via coupling component is electrically coupled to both the first electrode and a second metal trace within the second inner metal layer 1026; a third via coupling component is electrically coupled to both a second electrode of the DCC 1010 and a third metal trace within the first inner metal layer 1024; a fourth via coupling component is electrically coupled to both the second electrode and a fourth metal trace within the second inner metal layer 1026.

Each of the aforementioned metal traces may be electrically coupled to a power or ground plane associated with the package substrate 1004. For example, the first metal trace may be electrically coupled to the second metal trace by means of a via, and the third metal trace may be electrically coupled to the fourth metal trace by means of another via. In this fashion, the via coupling components may be electrically coupled to power or ground planes within the first and second inner metal layers 1024, 1026, wherein the first and second inner metal layers are closer to the first insulator layer 1034 than the outer metal layers 1022, 1028.

According to one aspect, a first portion of the first via coupling component extends beyond a first edge of the first electrode of the DCC 1010. According to another aspect, a second portion of the first via coupling component is positioned within the first inner metal layer 1024. Similarly, a first portion of the second via coupling component may extend beyond a second edge of the first electrode, and a second portion of the second via coupling component may be positioned within the second inner metal layer 1026. According to one aspect, a first portion of the third via coupling component extends beyond a first edge of the second electrode of the DCC 1010. According to another aspect, a second portion of the third via coupling component is positioned within the first inner metal layer 1024. Similarly, a first portion of the fourth via coupling component may extend beyond a second edge of the second electrode, and a second portion of the fourth via coupling component may be positioned within the second inner metal layer 1026.

FIG. 11 illustrates a capacitor structure in another substrate in some implementations. FIG. 11 is similar to FIG. 10. However, one difference between FIG. 10 and 11 is that in FIG. 11, the substrate 1004 does not include one or more via coupling components (e.g., via coupling component 1040 of FIG. 10).

Having described various examples of coupled inductor structures, a method for operating a coupled inductor structure will now be described below.

### Exemplary Electronic Devices

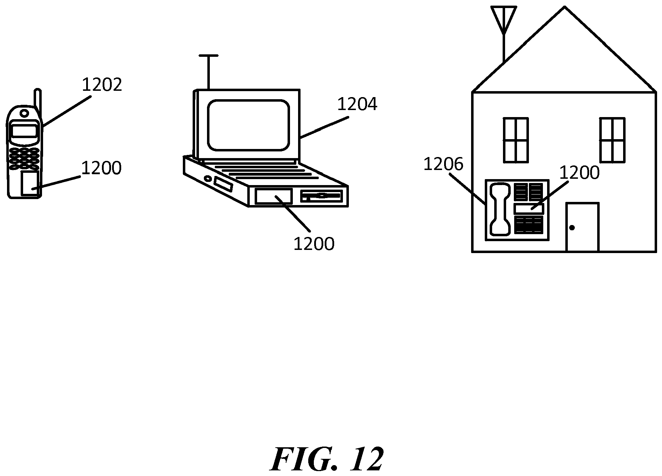

FIG. 12 illustrates various electronic devices that may be integrated with any of the aforementioned integrated circuit, die or package. For example, a mobile telephone 1202, a laptop computer 1204, and a fixed location terminal 1206 may include an integrated circuit (IC) 1200 as described herein. The IC 1200 may be, for example, any of the integrated circuits, dice or packages described herein. The devices 1202, 1204, 1206 illustrated in FIG. 12 are merely exemplary. Other electronic devices may also feature the IC 1200 including, but not limited to, mobile devices, hand-held personal communication systems (PCS) units, portable data units such as personal digital assistants, GPS enabled devices, navigation devices, set top boxes, music players, video players, entertainment units, fixed location data units such as meter reading equipment, communications devices, smartphones, tablet computers or any other device that stores or retrieves data or computer instructions, or any combination thereof.

One or more of the components, steps, features, and/or functions illustrated in FIGS. 2, 3, 4A-4B, 5A-5B, 6, 7, 8, 9, 10, 11 and/or 12 may be rearranged and/or combined into a single component, step, feature or function or embodied in several components, steps, or functions. Additional elements, components, steps, and/or functions may also be added without departing from the invention.

One or more of the components, steps, features and/or functions illustrated in the FIGs may be rearranged and/or combined into a single component, step, feature or function or embodied in several components, steps, or functions. Additional elements, components, steps, and/or functions may also be added without departing from novel features disclosed herein. The apparatus, devices, and/or components illustrated in the FIGs may be configured to perform one or more of the methods, features, or steps described in the FIGs. The novel algorithms described herein may also be efficiently implemented in software and/or embedded in hardware.

The word "exemplary" is used herein to mean "serving as an example, instance, or illustration." Any implementation or aspect described herein as "exemplary" is not necessarily to be construed as preferred or advantageous over other aspects of the disclosure. Likewise, the term "aspects" does not require that all aspects of the disclosure include the discussed feature, advantage or mode of operation. The term "coupled" is used herein to refer to the direct or indirect coupling between two objects. For example, if object A physically touches object B, and object B touches object C, then objects A and C may still be considered coupled to one another-even if they do not directly physically touch each other. The term "die package" is used to refer to an integrated circuit wafer that has been encapsulated or packaged or encapsulated.

Also, it is noted that the embodiments may be described as a process that is depicted as a flowchart, a flow diagram, a structure diagram, or a block diagram. Although a flowchart may describe the operations as a sequential process, many of the operations can be performed in parallel or concurrently. In addition, the order of the operations may be re-arranged. A process is terminated when its operations are completed. A process may correspond to a method, a function, a procedure, a subroutine, a subprogram, etc. When a process corresponds to a function, its termination corresponds to a return of the function to the calling function or the main function.

Those of skill in the art would further appreciate that the various illustrative logical blocks, modules, circuits, and algorithm steps described in connection with the embodiments disclosed herein may be implemented as electronic hardware, computer software, or combinations of both. To clearly illustrate this interchangeability of hardware and software, various illustrative components, blocks, modules, circuits, and steps have been described above generally in terms of their functionality. Whether such functionality is implemented as hardware or software depends upon the particular application and design constraints imposed on the overall system.

The various features of the invention described herein can be implemented in different systems without departing from the invention. It should be noted that the foregoing aspects of the disclosure are merely examples and are not to be construed as limiting the invention. The description of the aspects of the present disclosure is intended to be illustrative, and not to limit the scope of the claims. As such, the present teachings can be readily applied to other types of apparatuses and many alternatives, modifications, and variations will be apparent to those skilled in the art.

## Claims

1. An inductor structure (200) comprising:
a planar silicon substrate (202);
a first inductor winding (204) integrated in the silicon substrate, wherein the first inductor winding comprises first and second terminals (208,210);
a second inductor winding (206) integrated in the silicon substrate, wherein the second inductor winding comprises third and fourth terminals (212,214);
a first ferromagnetic layer (420) on a first side of the silicon substrate; and
a second ferromagnetic layer (422) on a second side of the silicon substrate opposite the first side of the silicon substrate;
wherein the silicon substrate is laterally located between the first inductor winding and the second inductor winding,
wherein the first inductor winding and the second inductor winding are laterally co-planar within the silicon substrate,
wherein the terminals of the first and second inductor windings are through substrate vias which traverse the entire silicon substrate,
wherein the first and second ferromagnetic layers are configured to provide magnetic shielding for the inductor structure, and
wherein both sides of one or more of the terminals of the first and second inductor windings are exposed through a portion of both the first and second ferromagnetic layers.

2. The inductor structure of claim 1, wherein the first inductor winding has a first spiral shape and the second inductor winding has a second spiral shape; or wherein the first inductor winding and the second inductor winding have an elongated circular shape.

3. The inductor structure of claim 1, wherein a thickness of the first inductor winding is less than 0.2 millimeters.

4. The inductor structure of claim 1, wherein the apparatus is integrated on a package-on-package structure, or wherein the apparatus is integrated on a surface of a package substrate, or wherein the apparatus is integrated inside a package substrate.

5. The inductor structure of claim 1, wherein the apparatus is incorporated into at least one of a music player, a video player, an entertainment unit, a navigation device, a communications device, a mobile device, a mobile phone, a smartphone, a personal digital assistant, a fixed location terminal, a tablet computer, and/or a laptop computer.

6. A method for providing an inductor structure, comprising:
providing a silicon substrate layer (202),;
forming cavities in the silicon substrate;
filling the cavities with electrically conductive material to provide a first inductor winding (204) and a second inductor winding (206), such that the first inductor winding and the second inductor winding are laterally co-planar within the silicon substrate and the silicon substrate is laterally located between the first inductor winding and the second inductor winding;
providing a first ferromagnetic layer (420) on a first side of the silicon substrate;
providing a second ferromagnetic layer (422) on a second side of the silicon substrate opposite the first side of the silicon substrate;
removing portion(s) of both the first and second ferromagnetic layers to expose both sides of one or more of the terminals of the first and second inductor windings,
wherein the first inductor winding comprises first and second terminals (208, 210)
wherein the second inductor winding comprises third and fourth terminals (212, 214),
wherein the first and second ferromagnetic layers are configured to provide magnetic shielding for the apparatus, and
wherein forming the cavities comprises forming the terminals of the first inductor winding and the second inductor winding as through substrate vias which traverse the entire silicon substrate.

7. The method of claim 6, further comprising thinning the silicon substrate.

8. The method of claim 6, further comprising providing the inductor structure on a package-on-package structure.

9. The inductor structure of claim 1, wherein the inductor structure is on a first surface of a package substrate, and electrically coupled to a die mounted on the first surface of the package substrate.

## Patentansprüche

1. Induktoranordnung (200), Folgendes umfassend:
ein planares Siliciumsubstrat (202);
eine erste Induktorwicklung (204), die in das Siliciumsubstrat integriert ist, wobei die erste Induktorwicklung einen ersten und einen zweiten Anschluss (208, 210) umfasst;
eine zweite Induktorwicklung (206), die in das Siliciumsubstrat integriert ist, wobei die zweite Induktorwicklung einen dritten und einen vierten Anschluss (212, 214) umfasst;
eine erste ferromagnetische Schicht (420) auf einer ersten Seite des Siliciumsubstrats; und
eine zweite ferromagnetische Schicht (422) auf einer zweiten Seite des Siliciumsubstrats gegenüber der ersten Seite des Siliciumsubstrats;
wobei sich das Siliciumsubstrat seitlich zwischen der ersten Induktorwicklung und der zweiten Induktorwicklung befindet, wobei die erste Induktorwicklung und die zweite Induktorwicklung innerhalb des Siliciumsubstrats seitlich koplanar sind, wobei die Anschlüsse der ersten und der zweiten Induktorwicklung Substratdurchkontaktierungen sind, die das gesamte Siliciumsubstrat durchlaufen, wobei die erste und die zweite ferromagnetische Schicht konfiguriert sind, eine magnetische Abschirmung für die Induktoranordnung bereitzustellen, und wobei beide Seiten eines oder mehrerer der Anschlüsse der ersten und der zweiten Induktorwicklung durch einen Abschnitt sowohl der ersten als auch der zweiten ferromagnetischen Schicht freigelegt sind.

2. Induktoranordnung nach Anspruch 1, wobei die erste Induktorwicklung eine erste Spiralform aufweist und die zweite Induktorwicklung eine zweite Spiralform aufweist; oder
wobei die erste Induktorwicklung und die zweite Induktorwicklung eine längliche Kreisform aufweisen.

3. Induktoranordnung nach Anspruch 1, wobei eine Dicke der ersten Induktorwicklung weniger als 0,2 Millimeter beträgt.

4. Induktoranordnung nach Anspruch 1, wobei die Einrichtung auf einer Gehäuse-auf-Gehäuse-Anordnung integriert ist oder wobei die Einrichtung auf einer Oberfläche eines Gehäusesubstrats integriert ist, oder wobei die Einrichtung in einem Gehäusesubstrat integriert ist.

5. Induktoranordnung nach Anspruch 1, wobei die Einrichtung in einem Musikabspielgerät, einem Videoabspielgerät, einer Unterhaltungseinheit, einer Navigationsvorrichtung, einer Kommunikationsvorrichtung, einer Mobilvorrichtung, einem Mobiltelefon, einem Smartphone, einem persönlichen digitalen Assistenten, einem ortsfesten Endgerät, einem Tablet-Computer und/oder einem Laptop eingebaut ist.

6. Verfahren zum Bereitstellen einer Induktoranordnung, Folgendes umfassend:
Bereitstellen einer Siliciumsubstratschicht (202);
Ausbilden von Hohlräumen in dem Siliciumsubstrat;
Füllen der Hohlräume mit elektrisch leitendem Material, um eine erste Induktorwicklung (204) und eine zweite Induktorwicklung (206) derart bereitzustellen, dass die erste Induktorwicklung und die zweite Induktorwicklung innerhalb des Siliciumsubstrats seitlich koplanar sind und sich das Siliciumsubstrat seitlich zwischen der ersten Induktorwicklung und der zweiten Induktorwicklung befindet;
Bereitstellen einer ersten ferromagnetischen Schicht (420) auf einer ersten Seite des Siliciumsubstrats;
Bereitstellen einer zweiten ferromagnetischen Schicht (422) auf einer zweiten Seite des Siliciumsubstrats gegenüber der ersten Seite des Siliciumsubstrats;
Entfernen eines Abschnitts/von Abschnitten sowohl der ersten als auch der zweiten ferromagnetischen Schicht, um beide Seiten eines oder mehrerer der Anschlüsse der ersten und der zweiten Induktorwicklung freizulegen, wobei die erste Induktorwicklung den ersten und den zweiten Anschluss (208, 210) umfasst, wobei die zweite Induktorwicklung den dritten und den vierten Anschluss (212, 214) umfasst, wobei die erste und die zweite ferromagnetische Schicht konfiguriert sind, die magnetische Abschirmung für die Einrichtung bereitzustellen, und wobei das Ausbilden der Hohlräume das Ausbilden der Anschlüsse der ersten Induktorwicklung und der zweiten Induktorwicklung als Substratdurchkontaktierungen, die das gesamte Siliciumsubstrat durchlaufen, umfasst.

7. Verfahren nach Anspruch 6, ferner ein Ausdünnen des Siliciumsubstrats umfassend.

8. Verfahren nach Anspruch 6, ferner das Bereitstellen der Induktoranordnung auf einer Gehäuse-auf-Gehäuse-Anordnung umfassend.

9. Induktoranordnung nach Anspruch 1, wobei die Induktoranordnung auf einer ersten Oberfläche eines Gehäusesubstrats vorliegt und mit einem auf der ersten Oberfläche des Gehäusesubstrats angebrachten Chip elektrisch gekoppelt ist.

## Revendications

1. Structure d'inductance (200) comprenant :
un substrat de silicium plan (202) ;
un premier enroulement d'inducteur (204) intégré dans le substrat de silicium, le premier enroulement d'inducteur comprenant des première et seconde bornes (208, 210) ;
un second enroulement d'inducteur (206) intégré dans le substrat de silicium, le second enroulement d'inducteur comprenant des troisième et quatrième bornes (212, 214) ;
une première couche ferromagnétique (420) située sur un premier côté du substrat de silicium ; et
une seconde couche ferromagnétique (422) située sur une seconde face du substrat de silicium opposée à la première face du substrat de silicium ;
le substrat de silicium étant latéralement situé entre le premier enroulement d'inducteur et le deuxième enroulement d'inducteur,
le premier enroulement d'inducteur et le deuxième enroulement d'inducteur étant coplanaires latéralement à l'intérieur du substrat de silicium,
les bornes des premier et deuxième enroulements d'inducteur étant des interconnexions de substrat traversant qui traversent la totalité du substrat de silicium,
les première et seconde couches ferromagnétiques étant conçues pour fournir un blindage magnétique à la structure d'inducteur, et
les deux côtés d'au moins une borne des premier et second enroulements d'inductance étant exposés à travers une partie des deux premières et deuxièmes couches ferromagnétiques.

2. Structure d'inducteur selon la revendication 1, dans laquelle le premier enroulement d'inducteur présente une première forme en spirale et le deuxième enroulement d'inducteur présente une seconde forme en spirale ; ou
le premier enroulement inducteur et le deuxième enroulement inducteur ayant une forme circulaire allongée.

3. Structure d'inducteur selon la revendication 1, dans laquelle l'épaisseur du premier enroulement d'inducteur est inférieure à 0,2 mm.

4. Structure d'inducteur selon la revendication 1, dans laquelle le dispositif est intégré sur une structure du type boîtier sur boîtier, ou l'appareil étant intégré sur une surface d'un substrat de boîtier, ou l'appareil étant intégré à l'intérieur d'un substrat de boîtier.

5. Dispositif intégré selon la revendication 1, dans lequel le dispositif intégré est incorporé dans un lecteur de musique et/ou un lecteur vidéo et/ou une unité de divertissement et/ou un dispositif de navigation et/ou un dispositif de communication et/ou un dispositif mobile et/ou un téléphone portable et/ou un smartphone et/ou un assistant numérique personnel et/ou un terminal à position fixe et/ou un ordinateur tablette et/ou un ordinateur portable.

6. Procédé permettant de fournir une structure d'inducteur, consistant à :
apporter une couche de substrat de silicium (202) ;
former des cavités dans le substrat de silicium ;
remplir les cavités avec un matériau électriquement conducteur afin de former un premier enroulement d'inducteur (204) et un deuxième enroulement d'inducteur (206), de sorte que le premier enroulement d'inducteur et le deuxième enroulement d'inducteur soient coplanaires latéralement dans le substrat de silicium et que le substrat de silicium soit situé latéralement entre le premier enroulement d'inducteur et le deuxième enroulement d'inducteur ;
apporter une première couche ferromagnétique (420) située sur un premier côté du substrat de silicium ;
apporter une deuxième couche ferromagnétique (422) située sur un deuxième côté du substrat de silicium opposé au premier côté du substrat de silicium ;
enlever des parties des première et seconde couches ferromagnétiques afin d'exposer les deux côtés d'au moins une borne des premier et second enroulements d'inducteur,
le premier enroulement d'inducteur comprenant des première et seconde bornes (208, 210),
l'enroulement d'inducteur comprenant des troisième et quatrième bornes (212, 214), les première et seconde couches ferromagnétiques étant conçues pour fournir un blindage magnétique à l'appareil, et
la formation des cavités comprenant la formation des bornes du premier enroulement d'inducteur et du second enroulement d'inducteur comme des interconnexions de substrat traversant qui traversent la totalité du substrat de silicium.

7. Procédé selon la revendication 6, consistant en outre à amincir le substrat de silicium.

8. Procédé selon la revendication 6, consistant en outre à apporter la structure d'inducteur sur une structure de type boîtier sur boîtier.

9. Structure d'inducteur selon la revendication 1, dans laquelle la structure d'inducteur est située sur une première surface d'un substrat de boîtier, et est couplée électriquement à une matrice montée sur la première surface du substrat de boîtier.
